(19) **Europäisches Patentamt**

**European Patent Office**

**Office européen des brevets**

(11) **EP 0 874 538 B1**

(12) **EUROPÄISCHE PATENTSCHRIFT**

(45) Veröffentlichungstag und Bekanntmachung des Hinweises auf die Patenterteilung:
**19.09.2001   Patentblatt 2001/38**

(51) Int Cl.$^7$: **H05K 5/03**, H05K 9/00

(21) Anmeldenummer: **98810163.0**

(22) Anmeldetag: **27.02.1998**

(54) **Baugruppenträger mit Abdeckblechen**

Electronic component with shielding sheets

Composant électronique avec tôles de blindage

(84) Benannte Vertragsstaaten:
**DE FR GB**

(30) Priorität: **25.04.1997   DE 29707528 U**

(43) Veröffentlichungstag der Anmeldung:
**28.10.1998   Patentblatt 1998/44**

(73) Patentinhaber: **ELMA Electronic AG**
**8620 Wetzikon (CH)**

(72) Erfinder: **Schindler, Walter A.**
**8055 Zürich (CH)**

(74) Vertreter: **Sulzer Management AG**
**KS/Patente/0007**
**Zürcherstrasse 12**
**8401 Winterthur (CH)**

(56) Entgegenhaltungen:
**EP-A- 0 627 876          DE-A- 3 503 813**
**DE-U- 1 719 823**

**Beschreibung**

Die Erfindung handelt von einem Baugruppenträger mit einem Abdeckblech und mit einem Längsprofil, welches einen durchgehenden Schlitz zum Einstekken einer Kante des Abdeckblechs aufweist.

Baugruppenträger für elektrische und elektronische Komponenten sind beispielsweise in den Normen der IEC Standards für die Gehäuse und Bauteile der 19-Zoll-Technik definiert und die verschiedensten Hersteller bieten Baugruppenträger in dieser Technik an. So zeigt ein Prospekt der Firma Knürr AG, Schatzbogen 29, D-81829 München, 19"-Baugruppenträger/ VME-System im Katalog 1997, deren Deckelblech an einem Frontprofil eingesteckt und mit diesem verprägt ist. Eine solche Verbindung schränkt den Einsatzbereich von Deckelblech und Frontprofil ein.

Aufgabe der Erfindung ist es daher für Baugruppenträger eine kraftschlüssige wiederholt steckbare Verbindung zwischen einem Längsprofil mit durchgehendem Schlitz und der Kante von einem Abdeckblech zu schaffen.

Diese Aufgabe wird mit den Kennzeichen vom unabhängigen Anspruch 1 dadurch gelöst, dass die Kante durch Schlitze oder Aussparungen unterbrochen ist, um federnde Zungen zu bilden und dass die an einem Schlitz oder an eine Aussparung angrenzenden Zungen wechselseitig einen Kontaktnoppen aufweisen, wobei ein äusserer Abstand a der Kontaktnoppen quer zum Blech grösser als die Breite b vom durchgehenden Schlitz ist, um beim Einstecken des Blechs eine vorgegebene Kontaktkraft über zwei wechselseitig angeordnete Noppen zu erzeugen.

Weitere Vorteile ergeben sich aus den Unteransprüchen 2 bis 13.

Die Anordnung hat den Vorteil, dass definierte Kontaktkräfte und eine nicht lotternde Verbindung zwischen Längsprofil und Abdeckblech geschaffen werden. Zur Schaffung einer solchen Verbindung sind keine weiteren Zwischenelemente notwendig, die zusätzliche Kosten verursachen und deren Werkstoff entsprechend seinem Potential in der Spannungsreihe bezüglich Korrosion zu berücksichtigen ist. Dies trifft besonders dann zu, wenn die Noppen mit einem Werkzeug aus dem Blech herausgedrückt sind. Da die Noppendimensionen in einem solchen Fall werkzeuggebundene Masse sind, können sie in einer grossen Wiederholgenauigkeit hergestellt werden. Längsprofile in dieser Technik stammen meist aus Extrudierwerkzeugen, sodass auch ihre durchgehenden Schlitze nur in geringen Toleranzen schwanken. Es sind daher hohe Kontaktdrücke möglich, wobei die eingesteckten vorgespannten Zungen Masstoleranzen ausgleichen. Ein Abstand von zwei wechselseitig und durch einen Schlitz getrennten Noppen kann klein gewählt werden, um Schlitz und Noppen in einem Werkzeug zum Beispiel auf einer CNC-Stanzmaschine herzustellen. Die Schlitze mit ihren zugehörigen Noppen sind dann mit einem Werkzeug in unterschiedlich wählbaren Abständen 1 ausführbar. Falls dieser Abstand 1 ebenfalls klein gewählt wird, sind über die ganze Länge der Verbindung Noppen in kurzen Abständen verteilt und es entstehen bezüglich Abschirmung nur sehr kleine Maschen für den Baugrüppenträger als Faraday'schen Käfig.

Längsprofil und Blech sind aus Metall. Ueblich sind extrudierte Längsprofile aus einer Aluminium-Legierung. Wenn diese mit einem Aluminium-Blech verbunden werden, dessen Noppen aus dem Blech herausgedrückt sind, wird die Korrosionsanfälligkeit wegen unterschiedlichen Spannungspotentialen besonders klein. Es können aber auch ohne weiteres Stahlbleche verwendet werden.

Dank einem erreichbaren hohen Kontaktdruck können die Noppen Schutzschichten und Verunreinigungen, die zwischen Kontaktpunkt und Längsprofil liegen, beim Einsetzen des Blechs abstreifen. Bei einer Beschichtung der Bleche mit einer Schutzschicht ist daher das Abdecken der Noppen nicht zwingend.

Durch den direkten definierten Kontakt zwischen Blech und Längsprofil entfallen auch die Kosten für separate Kontaktfedern. Dadurch, dass viele wechselseitig belastete Noppenpaare längs dem durchgehenden Schlitz des Längsprofils angeordnet sind, heben sich die aus dem Versatz der Noppen entstehenden Momente auf und die Lage vom Blech wird kraftabhängig ausgemittelt. Falls die Bleche hinter dem Einsteckschlitz abgekröpft sind, können sie in einer Ebene der Aussenkontur des Längsprofils weitergeführt werden. Der durchgehende Schlitz im Längsprofil muss nicht notwendigerweise senkrecht zur Aussenkontur ausgeführt sein. Er kann auch einen schrägen Winkel zu der Aussenkontur bilden. Empfehlenswert sind Schlitzformen mit Einläufen in Form von Radien oder Anschrägungen.

Im folgenden wird die Erfindung anhand von Ausführungsbeispielen beschrieben. Es zeigen:

Fig. 1    Schematisch einen Ausschnitt eines Abdeckblechs, dessen Kante wechselseitig versetzte, federnd gelagerte Noppen aufweist, die durch einen Schlitz getrennt sind;

Fig. 2    schematisch eine Ausführung analog zu Fig. 1 bei der der Schlitz zu einer breiteren Aussparung erweitert wurde;

Fig. 3    schematisch eine Ausführung analog zu Fig. 1 bei der die wechselseitig versetzten Noppen jeweils auf Zungen liegen, die durch zwei parallele Schlitze begrenzt sind;

Fig. 4    schematisch eine Ausführung analog zu Fig. 2 bei der die Aussparung im Blech so erweitert ist, dass die Noppen auf Zungen liegen, die parallel zur Kante vom Blech verlaufen;

Fig. 5a     schematisch einen Schnitt durch das Blech nach Fig. 1 mit wechselseitig versetzten Noppen;

Fig. 5b     schematisch einen Schnitt durch ein zu Fig. 5a passendes Längsprofil mit einem durchgehenden Schlitz für die Aufnahme vom Blech;

Fig. 6      schematisch ein doppelt abgekröpftes Blech, das in einem Längsprofil nach Fig. 5b eingesteckt ist und in einer Ebene der Aussenkontur vom Längsprofil verläuft; und

Fig. 7      schematisch einen vergrösserten Ausschnitt einer Blechkante mit zwei wechselseitig versetzten Noppen.

In den Figuren sind zu einem Baugruppenträger Kombinationen von Abdeckblechen 1 mit einem Längsprofil 2 gezeigt, welches einen durchgehenden Schlitz zum Einstecken einer Kante 4 eines Abdeckblechs 1 aufweist. Dadurch, dass die Kante 4 durch Schlitze 5 oder Aussparungen 6 unterbrochen ist, um federnde Zungen 7 zu bilden, und dass die an einem Schlitz 5 angrenzenden Zungen 7 wechselseitig einen vorstehenden Kontaktnoppen 8, 9 aufweisen, können die Zungen 7 beim Einstecken des Blechs 1 vorgespannt werden und eine Kontakt- und Haltekraft erzeugen.

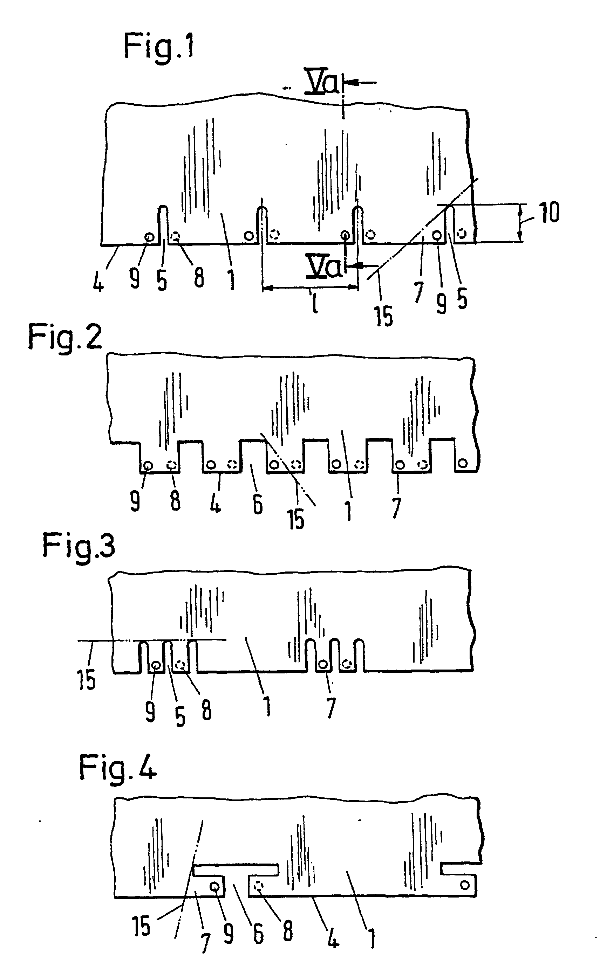

In Fig. 1 ist eine Kante 4 eines Abdeckblechs in Abständen 1 mit Schlitzen 5 versehen, die eine gleiche Tiefe 10 aufweisen. Wechselseitig versetzte Noppen 8, 9 sind jeweils an einem Schlitz 5 nahe der Kante 4 angebracht, sodass in Bezug auf den Noppen 8, 9 dieser auf einer federnden Zunge 7 vorsteht, die durch den Schlitz 5 und durch einen Teil der Kante 4 begrenzt ist und die an einer fiktiven Einspannlinie 15 durch das Blech 1 fortgesetzt ist. Die an einem Schlitz 5 angrenzenden Noppen können mit dem Schlitz selbst in einem einzigen Umformwerkzeug hergestellt werden, was für eine hohe Wiederholgenauigkeit der Abmessungen der Noppen von Vorteil ist, während der Abstand 1 zwischen zwei Schlitzen frei wählbar ist.

In Fig. 2 sind lediglich die Schlitze zu Aussparungen 6 mit einer grösseren Breite erweitert worden. Bei einem einzigen Umformwerkzeug wäre diese Breite ein werkzeuggebundenes Mass.

In Fig. 3 sind die Kontaktnoppen 8, 9 jeweils auf Zungen 7 angebracht, die jeweils durch gleich tiefe, senkrecht von der Kante 4 wegstehende Schlitze gebildet sind. Die fiktive Einspannlinie 15 für die Zungen 7 verläuft auf der Höhe vom Schlitzgrund und parallel zur Kante 4.

In Fig. 4 ist die Aussparung 6 im inneren Bereich und parallel zur Kante 4 soweit erweitert worden, dass Zungen 7 entstehen, die parallel zur äusseren Kante 4 verlaufen. Die fiktive Einspannlinie 15 ist um einen geringen Winkel von einer Senkrechten zur Kante 4 versetzt.

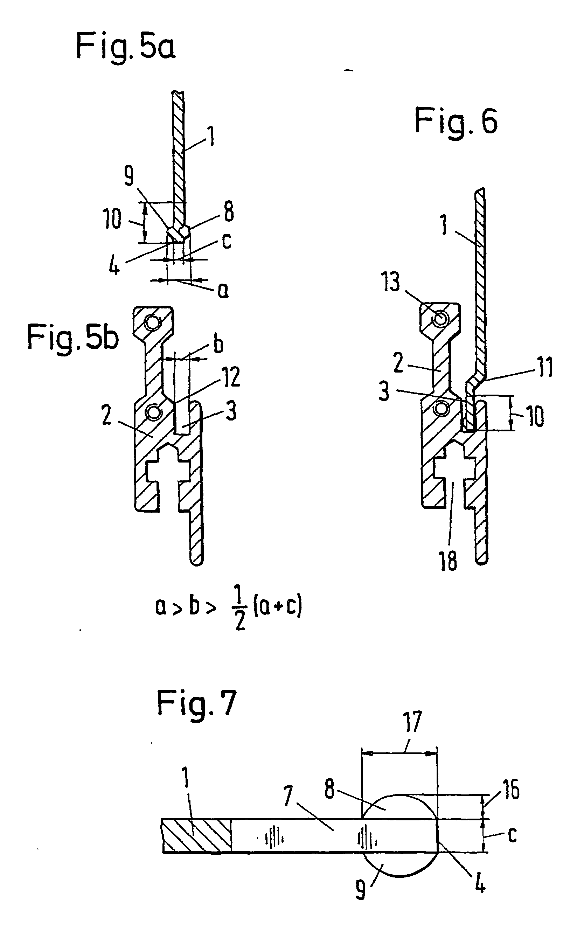

In den Figuren 5a, 5b sind Blech 1 und Längsprofil 2 vor dem Einstecken der Kante 4 des Blechs gezeigt. Die wechselseitig vorstehenden Noppen 8, 9 ergeben einen Abstand a der grösser als die Schlitzbreite b ist, um den federnden Zungenteil jeweils über die einfahrenden Noppen vorzuspannen, während die Schlitzbreite mehr, als die Summe der Höhe 16 einer Noppe (siehe Fig. 7) und der Blechdicke c ausmacht, betragen muss, damit das Blech einsteckbar ist. Bei gleicher Höhe 16 für die Noppen 8, 9 ergibt sich eine Höhe 16 von ½ (a-c) und die Bedingung a > b > ½ (a+c), um sicher einstecken zu können. Die Tiefe 10 vom nicht sichtbaren Schlitz 5 muss so gewählt werden, dass keine Ueberdehnung der Zunge stattfindet.

In Fig. 6 sind Blech 1 mit Abkröpfung 11 und Längsprofil 2 im Eingriff gezeigt. Neben dem durchgezogenen Schlitz 3 sind am Längsprofil ein Profil 18 für eine Gewindeleiste und Gewindebohrungen 13 für die Befestigung von Seitenteilen angebracht. Längsprofil 2 und Blech 1 fluchten in einer gemeinsamen Ebene.

In Fig. 7 beginnen die Noppen 8, 9 unmittelbar an der Kante 4 und steigen sanft bis zu einem höchsten Kontaktpunkt an. In diesem Beispiel sind die Noppen 8, 9 mit einem Durchmesser 17 als Ausschnitte von Kugelflächen ausgeführt.

Typische Abmessungen für Baugruppenträger in der 19"-Technik sind zum Beispiel:

Blechdicke c: 1 mm
äusserer Abstand a der Noppen: 2,36 mm
Breite vom Schlitz im Längsprofil: 1,8 bis 2,2 mm

**Patentansprüche**

1.  Baugruppenträger mit einem Abdeckblech (1) und mit einem Längsprofil (2), welches einen durchgehenden Schlitz (3) zum Einstecken einer Kante (4) des Abdeckblechs (1) aufweist, **dadurch gekennzeichnet, dass** die Kante durch Schlitze (5) oder Aussparungen (6) unterbrochen ist, um federnde Zungen (7) zu bilden und dass die an einem Schlitz (5) oder an eine Aussparung (6) angrenzenden Zungen (7) wechselseitig einen Kontaktnoppen (8, 9) aufweisen, wobei ein äusserer Abstand a der Kontaktnoppen (8, 9) quer zum Blech (1) grösser als die Breite b vom durchgehenden Schlitz (3) ist, um beim Einstecken des Blechs (1) eine vorgegebene Kontaktkraft über zwei wechselseitig angeordnete Noppen (8, 9) zu erzeugen.

2.  Baugruppenträger nach Anspruch 1, **dadurch gekennzeichnet, dass** Blechdicke c, Breite b und äusserer Abstand a der Kontaktnoppen so auf das Material vom Blech (1) abgestimmt sind, dass die Zungen (7) beim Einstecken im elastischen Bereich belastet sind.

**3.** Baugruppenträger nach einem der Ansprüche 1 oder 2, **dadurch gekennzeichnet, dass** die Schlitze (5) oder Aussparungen (6) von der Kante (4) senkrecht in das Blech (1) hineinragen und dass die Noppen (8, 9) nahe der Kante und zum Schlitz hin positioniert sind, um fiktive Einspannlinien (15) für die Zungen (7) zu erzeugen, die vom Schlitzgrund schräg zur Kante (4) verlaufen.

**4.** Baugruppenträger nach einem der Ansprüche 1 oder 2, **dadurch gekennzeichnet, dass** zwei benachbarte, wechselseitig angeordnete Noppen (8, 9) jeweils auf einer Zunge (7) angeordnet sind, die durch senkrecht zur Kante (4) stehende Schlitze (5) begrenzt ist.

**5.** Baugruppenträger nach Anspruch 4, **dadurch gekennzeichnet, dass** die Schlitze (5) gleich tief sind, um eine zur Kante (4) parallel laufende fiktive Einspannlinie (15) für die Zungen (7) zu bilden.

**6.** Baugruppenträger nach einem der Ansprüche 1 bis 3, **dadurch gekennzeichnet, dass** Aussparungen (6) in einer bestimmten Tiefe im Blech (1) parallel zur Kante (4) erweitert sind, um quer liegende Zungen (7) zu erzeugen.

**7.** Baugruppenträger nach einem der Ansprüche 1 bis 6, **dadurch gekennzeichnet, dass** das Blech (1) im eingesteckten Zustand ausserhalb vom durchgehenden Schlitz (3) abgekröpft ist (11), um mit seiner Fläche in einer Ebene der Aussenkontur des Längsprofils (2) weiterzuverlaufen.

**8.** Baugruppenträger nach einem der Ansprüche 1 bis 7, **dadurch gekennzeichnet, dass** der durchgehende Schlitz (3) Einläufe in Form von Radien oder Schrägflächen (12) aufweist.

**9.** Baugruppenträger nach einem der Ansprüche 1 bis 8, **dadurch gekennzeichnet, dass** die Noppen mit ihrer Kontur sanft zu einem Kontaktpunkt ansteigen, welcher in einer Ebene parallel zur Blechebene liegt.

**10.** Baugruppenträger nach einem der Ansprüche 1 bis 9, **dadurch gekennzeichnet, dass** die Noppen (8, 9) mit einem Werkzeug aus dem Blech (1) herausgedrückt sind, um ein zusammenhängendes Teil aus gleichem Material zu bilden.

**11.** Baugruppenträger nach einem der Ansprüche 1 bis 10, **dadurch gekennzeichnet, dass** Bleche (1) mit einer Schutzschicht überzogen sind.

**12.** Baugruppenträger nach einem der Ansprüche 1 bis 11, **dadurch gekennzeichnet, dass** die Abmessungen von Blech (1) und Längsprofil (2) der Bedingung

$$a > b > \tfrac{1}{2}\,(a+c)$$ entsprechen.

**13.** Baugruppenträger nach einem der Ansprüche 1 bis 12, **dadurch gekennzeichnet, dass** er in den Dimensionen der 19 Zoll Baugruppenträger ausgeführt ist.

**Claims**

**1.** Module carrier comprising a sheet metal cover (1) and a longitudinal section (2) having a continuous slot (3) for the insertion of an edge (4) of the sheet metal cover (1), **characterised in that** the edge is interrupted by slits (5) or recesses (6) in order to form resilient tongues (7); and in that the tongues (7) bounding a slit (5) or a recess (6) have a contact noses (8, 9) at alternate sides, with an outer distance a of the contact noses (8, 9) transverse to the sheet metal part (1) being greater than the width b of the continuous slot (3) in order to produce a predetermined contact force via two noses (8, 9) at alternate sides when the sheet metal part (1) is inserted.

**2.** Module carrier in accordance with claim 1, **characterised in that** the sheet metal part thickness c, the width b and the outer distance a of the contact noses are matched to the material of the sheet metal part (1) such that the tongues (7) are stressed within the elastic range on insertion.

**3.** Module carrier in accordance with any one of the claims 1 or 2, **characterised in that** the slits (5) or recesses (6) project perpendicularly from the edge (4) into the sheet metal part (1); and in that the noses (8, 9) are positioned near the edge and towards the slit in order to produce imagined clamping lines (15) for the tongues (7) which extend at an inclination from the end of the slit to the edge (4).

**4.** Module carrier in accordance with any one of the claims 1 or 2, **characterised in that** two adjacent noses (8, 9) at alternate sides are each arranged on a tongue (7) which is bounded by slits (5) which are perpendicular to the edge (4) .

**5.** Module carrier in accordance with claim 4, **characterised in that** the slits (5) are equally deep in order to form an imagined clamping line (15) for the tongues (7) extending parallel to the edge (4).

**6.** Module carrier in accordance with any one of the claims 1 to 3, **characterised in that** recesses (6) are broadened at a certain depth in the sheet metal part (1) parallel to the edge (4) in order to produce transversely lying tongues (7) .

7. Module carrier in accordance with any one of the claims 1 to 6, **characterised in that** the sheet metal part (1) is bent (11) outside the continuous slot (3) in the inserted state in order to continue to extend with its surface in a plane of the outer contour of the longitudinal section (2) .

8. Module carrier in accordance with any one of the claims 1 to 7, **characterised in that** the continuous slot (3) has inlets in the form of radii or inclined surfaces (12) .

9. Module carrier in accordance with any one of the claims 1 to 8, **characterised in that** the contour of the noses rise gently to a contact point in a plane parallel to the plane of the sheet metal part.

10. Module carrier in accordance with any one of the claims 1 to 9, **characterised in that** the noses (8, 9) are pressed from the sheet metal part (1) with a tool in order to form a unitary part of the same material.

11. Module carrier in accordance with any one of the claims 1 to 10, **characterised in that** sheet metal parts (1) are coated with a protective layer.

12. Module carrier in accordance with any one of the claims 1 to 11, **characterised in that** the dimensions of the sheet metal part (1) and the longitudinal section (2) are in accordance with the condition

$$a > b > \tfrac{1}{2} (a+c).$$

13. Module carrier in accordance with any one of the claims 1 to 12, **characterised in that** it is executed in the dimensions of the 19 inch module carrier.

**Revendications**

1. Support de composant avec une tôle de blindage (1) et avec un profilé longitudinal (2) qui présente une fente traversante (3) pour insérer une arête (4) de la tôle de blindage (1), **caractérisé en ce que** l'arête est interrompue par des fentes (5) ou des évidements (6) pour former des languettes élastiques (7) et en ce que les languettes (7) avoisinant une fente (5) ou un évidement (6) présentent mutuellement un téton de contact (8, 9), où un écart extérieur a des tétons de contact (8, 9) transversalement à la tôle (1) est plus grand que la largeur b de la fente traversante (3) pour, lors de l'insertion de la tôle (1), produire une force de contact prédéfinie par deux tétons (8, 9) disposés réciproquement.

2. Support de composant selon la revendication 1, **caractérisé en ce que** l'épaisseur de tôle c, la largeur b et l'écart extérieur a des tétons de contact sont accordés au matériau de la tôle (1) de façon que les languettes (7), lors de l'insertion dans la zone élastique, soient chargées.

3. Support de composant selon l'une des revendications 1 ou 2, **caractérisé en ce que** les fentes (5) ou les évidements (6) font saillie de l'arête (4) verticalement dans la tôle (1) et en ce que les tétons (8, 9) sont positionnés près de l'arête et vers la fente pour produire des lignes de serrage fictives (15) pour les languettes (7) qui s'étendent depuis le fond de la fente en biais vers l'arête (4).

4. Support de composant selon l'une des revendications 1 ou 2, **caractérisé en ce que** deux tétons avoisinants (8, 9) disposés mutuellement sont disposés respectivement sur une languette (7) qui est délimitée par des fentes (5) s'étendant perpendiculairement à l'arête (4).

5. Support dé composant selon la revendication 4, **caractérisé en ce que** les fentes (5) ont la même profondeur pour former une ligne de serrage fictive (15), s'étendant parallèlement à l'arête (4) pour les languettes (7).

6. Support de composant selon l'une des revendications 1 à 3, **caractérisé en ce que** des évidements (6) dans une profondeur déterminée dans la tôle (1) sont élargis parallèlement à l'arête (4) pour produire des languettes (7) s'étendant transversalement.

7. Support de composant selon l'une des revendications 1 à 6, **caractérisé en ce que** la tôle (1), à l'état inséré, est coudée (11) à l'extérieur de la fente traversante (3) pour continuer à s'étendre avec sa face dans un plan du contour extérieur du profilé longitudinal (2).

8. Support de composant selon l'une des revendications 1 à 7, **caractérisé en ce que** la fente traversante (3) présente des entrées sous la forme de rayons ou de faces inclinées (12).

9. Support de composant selon l'une des revendications 1 à 8, **caractérisé en ce que** les tétons remontent avec leur contour en douceur vers un point de contact qui se situe dans un plan parallèle au plan de la tôle.

10. Support de composant selon l'une des revendications 1 à 9, **caractérisé en ce que** les tétons (8, 9) sont poussés avec un outil hors de la tôle (1) pour former une partie continue dans le même matériau.

**11.** Support de composant selon l'une des revendications 1 à 10, **caractérisé en ce que** les tôles (1) sont revêtues d'une couche de recouvrement.

**12.** Support de composant selon l'une des revendications 1 à 11, **caractérisé. en ce que** les dimensions de la tôle (1) et du profilé longitudinal (2) répondent à la condition a > b > ½ (a+c).

**13.** Support de composant selon lune des revendications 1 à 12, **caractérisé en ce qu'**il est réalisé dans les dimensions des supports de composant de 19 pouces.

Fig.1

Fig.2

Fig.3

Fig.4

## Fig.5a

1

9
10
8
c
4
a

## Fig.5b

b
12
2
3

$$a > b > \frac{1}{2}(a+c)$$

## Fig.6

1
13
2
3
11
10
18

## Fig.7

1
7
8
17
16
c
4
9